**Europäisches Patentamt**

**European Patent Office**

**Office européen des brevets**

(11) Veröffentlichungsnummer : **0 527 995 B1**

(12)
# EUROPÄISCHE PATENTSCHRIFT

(45) Veröffentlichungstag der Patentschrift :
**27.09.95 Patentblatt 95/39**

(51) Int. Cl.$^6$ : **G01P 3/36,** G01S 17/50, G01S 17/02, G01P 5/00

(21) Anmeldenummer : **92905824.6**

(22) Anmeldetag : **06.03.92**

(86) Internationale Anmeldenummer :
**PCT/EP92/00500**

(87) Internationale Veröffentlichungsnummer :
**WO 92/15888 17.09.92 Gazette 92/24**

(54) **ELEKTRISCHE SCHALTUNG ZUM MESSEN DER FREQUENZ VON LASERDOPPLERSIGNALEN.**

(30) Priorität : **06.03.91 DE 9102669 U**

(43) Veröffentlichungstag der Anmeldung :
**24.02.93 Patentblatt 93/08**

(45) Bekanntmachung des Hinweises auf die
Patenterteilung :
**27.09.95 Patentblatt 95/39**

(84) Benannte Vertragsstaaten :
**BE DE FR GB**

(56) Entgegenhaltungen :
**US-A- 4 715 706**
**US-A- 4 974 960**
**"Theorie und Praxis der Laser-Doppler-Ane-**
**mometrie", Franz Durst et al., Karlsruhe (DE),**
**1987, S.316-357**

(73) Patentinhaber : **Mesacon Gesellschaft für**
**Messtechnik mbH**
**Martin-Schmeisser-Weg 15**
**D-44227 Dortmund (DE)**

(72) Erfinder : **GONDRUM, Uwe**
**Schubertstrasse 6**
**D-4354 Datteln (DE)**
Erfinder : **FÜTTERER, Martin**
**Bergische Strasse 21**
**D-5840 Schwerte (DE)**
Erfinder : **MILBRADT, Frank**
**Schneiderstrasse 87**
**D-4600 Dortmund 50 (DE)**
Erfinder : **GREBE, Volker**
**Zur Burkuhle 54**
**D-4630 Bochum (DE)**

(74) Vertreter : **Patentanwälte Wenzel & Kalkoff**
**Postfach 24 48**
**D-58414 Witten (DE)**

**Beschreibung**

Die Erfindung betrifft eine elektrische Schaltung zum Bestimmen der Frequenz von Laserdoppler-Signalen innerhalb eines Meßintervalls mit

- einem Zähler zum Zählen der Laserdoppler-Signalimpulse,
- einem Zeitimpulsgeber, beispielsweise einem Quarzimpulsgeber, zum Erzeugen von Zeitimpulsen,
- einem Zähler zum Zählen der Zeitimpulse,
- einem dem Signalimpulszähler vorgeschalteten, von einem Zusatzsignal gesteuerten ersten Sperrelement, beispielsweise einem ersten UND-Gatter, zur Steuerung der Zählung der Signalimpulse, wobei das Zusatzsignal, beispielsweise von einem automatischen Bandpaß, das Vorhandensein gültiger Signalimpulse anzeigt,
- einem dem Zeitimpulszähler vorgeschalteten, von dem Zusatzsignal gesteuerten zweiten Sperrelement, beispielsweise einem zweiten UND-Gatter, zur Steuerung der Zählung der Zeitimpulse,
- einer zum Auslesen der Zählerstände nach Ablauf eines Meßintervalls mit dem Signalimpulszähler und dem Zeitimpulszähler verbundenen Steuereinrichtung, beispielsweise einem Mikroprozessor;

sowie ein Verfahren zum Bestimmen der Frequenz von Laserdoppler-Signalen innerhalb eines Meßintervalls.

Insbesondere bei der Messung der Geschwindigkeit einer bewegten Oberfläche mittels Laserstrahlen, die auf die bewegte Oberfläche geführt und deren reflektiertes Streulicht zur Bestimmung der Geschwindigkeitsinformation gemessen und ausgewertet wird, ergeben sich gewöhnlich Laserdopplersignale mit einer unerwünschten Amplituden-, Phasen- und Frequenzmodulation, die auf Interferenz im Meßvolumen beruht und durch Veränderungen der bewegten Oberfläche verursacht wird. Bei der Bestimmung der Frequenz von Laserdopplersignalen, die Geschwindigkeitsinformation beinhalten, wirkt sich diese Modulation sehr nachteilig aus. Denn für die Frequenzbestimmung wird die Anzahl der Signalimpulse, die innerhalb eines bestimmten Meßintervalls anfallen, beispielsweise mittels eines Standard-Frequenzzählers gezählt, und zwar in fest vorgegebenen asynchronen Intervallen. Als Folge der Modulation fallen aber während gewisser Zeiträume keine zählbaren Impulse an, so daß die ermittelte Frequenz fehlerhaft ist, nämlich unter der tatsächlich vorhandenen Frequenz liegt. Denn der Zähler zählt die Anzahl der Impulse innerhalb des vorgegebenen Zeitintervalls, und aus der Anzahl der gezählten Impulse wird durch Mittelung die Frequenz errechnet. Ergibt sich innerhalb des vorgegebenen Zeitintervalls eine relativ große Lücke, innerhalb derer kein zählbarer Impuls anfällt, wird der festgestellt Mittelwert ungenau.

In der Praxis hilft man sich durch eine möglichst feine Unterteilung der Meßintervalle, so daß Intervalle, in denen keine Impulse gezählt werden, verworfen werden und bei der Frequenzberechnung unberücksichtigt bleiben. Es bleibt jedoch auch im Falle der Unterteilung eines Meßintervalls in möglichst viele kleine Intervalle letztlich bei der gleichen Meßmethode, und der Unterschied liegt lediglich darin, daß durch die höhere Quantelung letztlich eine höhere Genauigkeit erzielt wird, allerdings ohne den Fehler grundsätzlich zu beseitigen. Denn hierzu wäre eine derart feine Unterteilung der Meßintervalle notwendig, daß noch viel mehr Rechenkapazität als heute mit der Auswertung der Meßintervalle befaßt wird.

Würde man ein Signal ableiten, das eine Aussage darüber liefert, ob Impulse vorhanden sind, beispielsweise abgeleitet von der Amplitude des Laserdopplersignals, können Informationen verlorengehen, da die Messung eines gesamten Intervalls verworfen wird, wenn auch nur zum geringsten Teil das Zusatzsignal "keine Impulse" gemeldet hat.

Statt einer Frequenzmessung ist auch eine Periodendauermessung möglich, aus deren Ergebnis mit Hilfe der Gleichung $f = 1/T$ die Frequenz errechenbar ist. Hier ist nur eine einzige gültige Schwingung zum Bestimmen der Frequenz notwendig. Dies geht auch sehr schnell. Aber dieser Weg ist letztlich ungenau, da die Periodendauer durch die eingangs erwähnte Phasen- und Frequenzmodulation starker, statistischer Variation unterworfen ist. Außerdem erfordert diese Methode einen hohen Meßaufwand und vor allem eine sehr leistungsfähige Hardware.

Aus dem Buch "Theorie und Praxis der Laser-Doppler-Anemometrie" von Franz Durst, Adrian Melling und James H. Whitelaw, erschienen 1987 in Karlsruhe, siehe insbesondere S.316-357, ist neben den bereits genannten Meßsystemen und -verfahren ein weiteres Laser-Doppler-Periodendauer-Meßsystem und -verfahren bekannt, das auf einer elektrischen Schaltung zum Bestimmen der Frequenz von Laserdoppler-Signalen innerhalb eines Meßintervalls mit einem Zähler (Nullstellendetektor) zum Zählen der Laserdoppler-Signalimpulse, einem Zeitimpulsgeber (stabilisierter Oszillator) zum Erzeugen von Zeitimpulsen und einem Zähler (elektronischer Zähler) zum Zählen der Zeitimpulse beruht. Das Laserdoppler-Signal wird einem Amplitudendiskriminator zugeleitet, der genau dann eine den Laserdoppler-Signalen zugeordnete Pulsfolge gültiger Nulldurchgänge an den Nullstellenzähler weitergibt, wenn das Laserdoppler-Signal bestimmte Bedingungen erfüllt. Aus der Pulsfolge gültiger Nulldurchgänge, d.h. aus dem Laserdoppler-Signal wird ein Zusatzsignal (Torzeit) erzeugt, das an den Zeitzähler weitergeleitet wird. Der Zeitzähler mißt die Signaldauer eines Laserdoppler-Signals durch Zählen der in die Torzeit fallenden Impulse des stabilisierten Oszillators. Nach dem Ende des Laserdoppler-Signals und damit nach Ablauf der Torzeit wird in einer Steuereinrichtung die Anzahl der Nulldurchgänge während des Dopplersignals mit der Zeitdauer für die erhaltenen Nulldurchgänge verknüpft. Die Information wird auf den Ausgang des Meßsystems weitergeleitet; sie kann aus der Signalzeitdauer und der Nullstellenanzahl oder aus der jeweiligen Doppler-Frequenz bestehen.

Es besteht die Aufgabe, eine elektrische Schaltung zu schaffen, mit der sich die Genauigkeit der Frequenzmessung aus Laserdoppler-Signalen sehr wesentlich erhöhen läßt, ohne daß hierfür ein unverhältnismäßig hoher Aufwand erforderlich ist.

Neuerungsgemäß wird die Aufgabe dadurch gelöst, daß der Zeitimpulszähler dazu ausgebildet ist, nach Erreichen einer vorgegebenen Anzahl von Zeitimpulsen, die das Meßintervall bestimmt, einen Auslesevorgang auszulösen, bei dem der Zählerstand des Signalimpulszählers und der Zählerstand des Zeitimpulszählers an den Mikroprozessor übermittelt und zur Bestimmung der Frequenz der Laserdoppler-Signale genutzt wird.

Es wird weiterhin Schutz für ein Verfahren zum Bestimmen der Frequenz von Laserdoppler-Signalen innerhalb eines Meßintervalls beantragt, bei dem

- ein Zusatzsignal erzeugt wird, das das Vorhandensein gültiger Laserdopplersignale anzeigt,
- die Laserdoppler-Signalimpulse von einem Signalimpulszähler gezählt werden, falls ein dem Signalimpulszähler vorgeschaltetes erstes Sperrelement, beispielsweise ein erstes UND-Gatter, aufgrund des Zusatzsignals entsperrt ist,
- von einem Zeitimpulsgeber, beispielsweise einem Quarzimpulsgeber, Zeitimpulse erzeugt werden,
- die Zeitimpulse von einem Zeitimpulszähler gezählt werden, falls ein den Zeitimpulszähler vorgeschaltetes zweites Sperrelement, beispielsweise ein zweites UND-Gatter, aufgrund des Zusatzsignals entsperrt ist,
- der Signalimpulszähler seinen Zählerstand nach Beendigung des Meßintervalls an eine Steuereinrichtung, beispielsweise einen Mikroprozessor überträgt;

dadurch gekennzeichnet, daß der Zeitimpulszähler nach Erreichen einer vorgegebenen Anzahl von Zeitimpulsen, die das Meßintervall bestimmt, einen Auslesevorgang auslöst, bei dem der Zählerstand des Signalimpulszählers und der Zählerstand des Zeitimpulszählers an den Mikroprozessor übermittelt und zur Bestimmung der Frequenz der Laserdopplersignale genutzt wird.

Der Lasersignal-Impulszähler wird neuerungsgemäß folglich durch ein Zusatzsignal, das vorzugsweise von einem automatischen Bandpaß abgegeben wird, gesteuert, so daß nur gültige Signale durch den Lasersignal-Impulszähler gezählt werden. Im Falle ungültiger Signalimpulse wird der Lasersignal-Impulszähler durch das Und-Gatter gesperrt. Die Zählung der Signale durch den Lasersignal-Impulszähler erhält ihren zeitlichen Bezug durch die Anordnung des Zeitimpulszählers, in dem ein fest definiertes Zeitintervall durch eine bestimmte Anzahl von Impulsen vorgegeben wird. Denn das Meßziel ist die Zählung der Laserdopplersignalimpulse in einem fest definierten Meßintervall, also in einer bestimmten Zeit. Neuerungsgemäß werden nun in dem Lasersignal-Impulszähler, gesteuert durch das Zusatzsignal, die Laserdopplersignalimpulse gezählt, während in dem anderen Zähler, nämlich dem Zeitimpulszähler, die Zeitimpulse beispielsweise in Form von Quarzimpulsen gezählt werden. Wenn das Meßintervall abgelaufen, also in dem Zeitimpulszähler die vorgegebene Anzahl von Impulsen gezählt und somit der Zeitimpulszähler auf den Wert Null gebracht ist, werden die Zählerstände beider Zähler durch den Mikroprozessor abgelesen, und der Quotient aus beiden Zählerständen führt unmittelbar zu der zu messenden Laserdopplerfrequenz und damit zu der gewünschten Geschwindigkeitsinformation.

Vorzugsweise ist der Zusatzsignalgeber zum Synchronisieren der Impulszählungen mit dem Lasersignal-Impulszähler und mit dem Zeitimpulszähler gekoppelt. Beide Zählvorgänge werden folglich durch das Zusatzsignal gesteuert. Dabei ist eine weitere Synchronisierung zwischen dem Zusatzsignal und den Zählersignalen zweckmäßig, um beim Ein-/Ausschalten der Zählung keine metastabilen Zustände oder eine Verfälschung der Impulsanzahlen zu erhalten.

Wie bereits beschrieben ist, läuft die Messung so lange, bis in den Zeitimpulszähler so viele Impulse eingezählt sind, daß das Meßintervall abgelaufen ist. Dann wird das Auslesen des Lasersignal-Impulszählers ausgelöst, und dies muß synchronisiert geschehen, damit ein gerade laufender Meßvorgang, vorgeben durch ein gültiges Zusatzsignal, nicht gestört wird.

Eine Weiterbildung der Neuerung besteht darin, daß der Lasersignal-Impulszähler eine derartige Verbindung mit dem Zeitimpulszähler aufweist, daß bei kleinen Laserdoppler-Frequenzen und folglich wenig Impulsen pro Meßintervall ein Übergang auf Periodendauermessung erfolgt. Die Neuerung läßt diesen Übergang ohne weiteres zu. Das bedeutet, daß das Auflaufen einer bestimmten Anzahl von Impulsen im Lasersignal-Impulszähler einen Interrupt auslöst und eine Ablesung des Zeitimpulszählers veranlaßt wird, so daß trotz niedriger Frequenz eine ausreichende Auflösung möglich ist. In diesem Falle wird das Meßintervall folglich nicht durch eine vorgegebene Anzahl von Impulsen des Zeitimpulszählers bestimmt, sondern durch eine bestimmte vorgegebene Anzahl von Lasersignalimpulsen, die eine Auslesung und einen Vergleich der Zählerstände herbeiführen.

Die neuerungsgemäße Anordnung hat gegenüber den herkömmlichen Systemen vor allem folgende Vorteile:

- kein Informationsverlust,
- selbständige Mittelung über das Meßintervall,
- keine Systembelastung durch hohe Takt- oder Intervallraten,
- Mittelwertintervall einstellbar,
- ununterbrochenes Messen möglich,
- direkte Lieferung der Frequenz als Quotient der beiden Zählerstände.

Weitere Vorteile der Neuerung ergeben sich aus der nachfolgenden Beschreibung sowie aus der Zeichnung eines Ausführungsbeispiels, das nachstehend mit Bezug auf die Zeichnung näher erläutert wird. In der Zeichnung ist schematisch eine elektrische Schaltung dargestellt, und zwar in

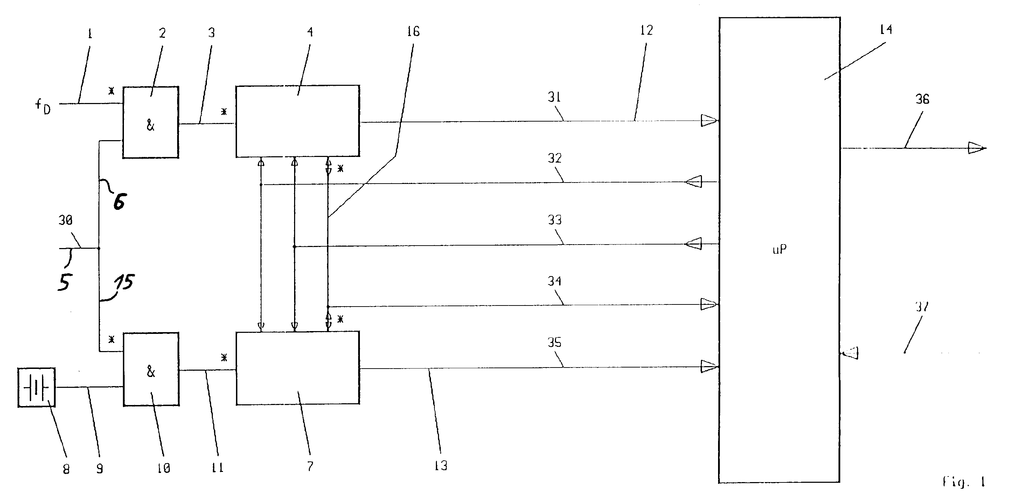

Fig. 1 ein Übersichtsschaltplan und in

Fig. 2 ein Detailauszug der Schaltung von Fig. 1 zur Darstellung einer Synchronisierung von Signalimpulsen.

Über eine Leitung 1 gelangen Impulse von Laserdopplersignalen mit der Frequenz $f_D$ zu einem Und-Gatter 2 und von dort über eine Leitung 3 zu einem Lasersignal-Impulszähler 4. Die Steuerung des Und-Gatters 2 erfolgt durch ein Zusatzsignal, das ausbleibt, wenn der das Zusatzsignal abgebende automatische Bandpaß Signale bzw. Impulse verwirft. Das Zusatzsignal erreicht das Und-Gatter 2 über Leitungen 5, 6.

Auf diese Weise kann der Lasersignal-Impulszähler 4 sämtliche Impulse zählen, die ihn über das Und-Gatter 2 erreichen, allerdings ohne den für die Messung bzw. die Auswertung erforderlichen Zeitbezug, der neuerungsgemäß durch einen Zeitimpulszähler 7 hergestellt wird, der nämlich von einem Quarzimpulsgeber 8 über eine Leitung 9, ein Und-Gatter 10 und eine Leitung 11 Impulse auf den Zeitimpulszähler 7 gibt, von denen eine vorgegebene Anzahl ein Meßintervall bildet. Wenn diese vorgegebene Anzahl von Impulsen in dem Zeitimpulszähler 7 gezählt ist, wird von ihm eine Auslesung des Lasersignal-Impulszählers 4 ausgelöst. Beide Zählerstände werden nun über eine Leitung 12 bzw. 13 einem Mikroprozessor 14 übermittelt, der die gewünschte Frequenzinformation aus dem Quotienten beider Zählerstände ermittelt. Anschließend wird der Zeitimpulszähler 7 auf Null gebracht.

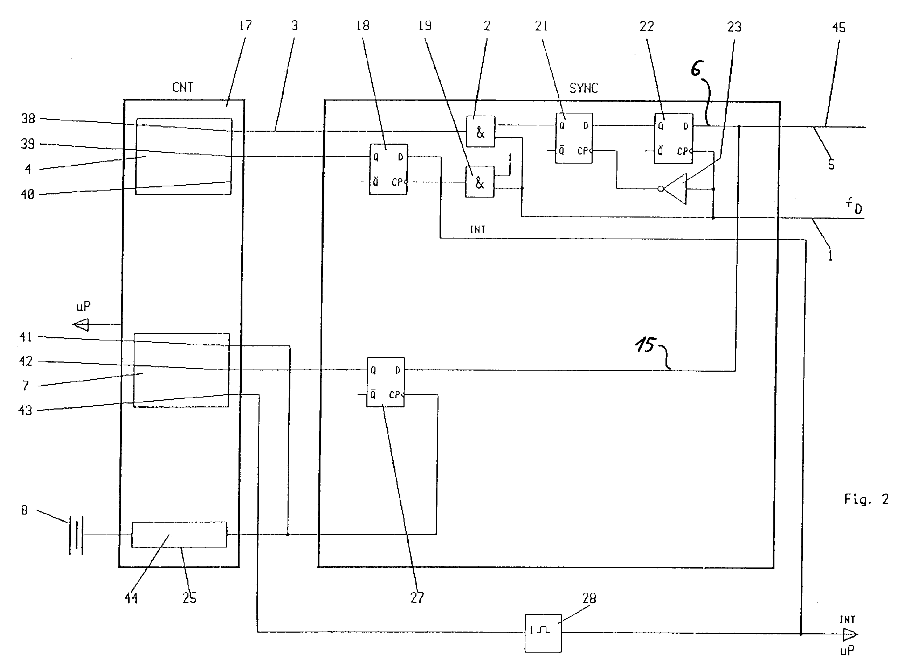

Damit sich zum Anfang und Ende eines Meßintervalls keine metastabilen Zustände oder eine Verfälschung der Impulsanzahlen ergeben, erfolgt eine Synchronisierung der von dem Lasersignal-Impulszähler 4 und vom den Zeitimpulszähler 7 zu zählenden Impulse durch das Zusatzsignal, das zu diesem Zweck über die Leitung 5 und eine Leitung 15 auch das Und-Gatter 10 steuert. Das Sternchenzeichen in der Zeichnung bedeutet, daß alle Verknüpfungen, Auslese-, Setz- und Rücksetzhandlungen mit dem jeweiligen Signal synchronisiert werden, wie es in der Schaltung von Fig. 2 dargestellt ist.

Eine Verbindung durch eine Leitung 16 zwischen dem Lasersignal-Impulszähler 4 und dem Zeitimpuslzähler 7 soll andeuten, daß sich die Messung im Falle der Unterschreitung einer bestimmten Anzahl von Impulsen pro Meßintervall, also wenn die Auflösung bei relativ kleinen Dopplerfrequenzen ungünstig wird, von einer Frequenz- in eine Periodendauermessung ändert. In diesem Falle wird das Meßintervall durch eine vorbestimmte Anzahl von in dem Lasersignal-Impulszähler auflaufenden Impulsen bestimmt. Wenn diese Anzahl von Impulsen erreicht ist, wird durch den Lasersignal-Impulszähler 4 eine Ablesung des Zählerstandes des Zeitimpulszählers 7 veranlaßt, und der abgelesene Zeitwert wird mit der vorgegebenen Impulszahl zur Bestimmung der Periodendauer, aus der die Frequenz errechenbar ist, verglichen.

Nachfolgend wird die Schaltung nach Fig. 2 beschrieben:

Der Impulszähler der Zähleinheit 17 soll die Dopplerfrequenz nur zählen, wenn das Zusatzsignal High-Pegel hat. Die Impulse von Laserdopplersignalen mit der Frequenz $f_D$ gelangen über das Und-Gatter 2 auf den Zähleingang (Source 1) des Impulszählers 4.

Da bei einer direkten Und-Verknüpfung der Impulse der Frequenz $f_D$ und dem Zusatzsignal einige Flanken der Impulse mit der Frequenz $f_D$ bei der Zählung verlorengehen bzw. sogar zusätzlich erzeugt werden, ist es notwendig, erst das Zusatzsignal mit den Impulsen mit der Frequenz $f_D$ zu synchronisieren und dann eine Und-Verknüpfung vorzunehmen.

Bei der Und-Verknüpfung im Und-Gatter 2 ist so sichergestellt, daß das Zusatzsignal nur dann steigende bzw. fallende Flanken aufweist, wenn der betreffende Impuls mit der Frequenz $f_D$ Low-Pegel hat, so daß keine zusätzliche Flanke bei der Und-Verknüpfung erzeugt wird bzw. verlorengeht.

Die Laufzeit der Flipflops 18, 21 und 27 sowie des Gatters 20 und des Inverters 23 beträgt ca. 50 ns.

Das Zusatzsignal (nämlich stets das Signal GÜLTIG), wird mit der steigenden Flanke der Impulse mit der Frequenz $f_D$ im Flipflop 22 übernommen und erscheint nach der Laufzeit am Ausgang Q des Flipflops 22 bzw. am Eingang D des Flipflops 21.

Das Flipflop 21 übernimmt das Signal bei fallender Flanke des betreffenden Impulses mit der Frequenz $f_D$ (Invertierung von $f_D$ im Inverter 23) und legt es nach der Laufzeit auf das Und-Gatter 2, dessen zweiter Eingang $f_D$ ist. Hieraus ergibt sich, daß sich das Zusatzsignal immer nur 50 ns nach der fallenden Flanke der Impulse mit der Frequenz $f_D$ ändern kann. Im Und-Gatter 2 erfolgt die Und-Verknüpfung. Hat das Zusatzsignal High-Pegel, so erscheinen die Impulse mit der Frequenz $f_D$ im Impulszähler 4.

Eine steigende Flanke an Gate 1 des Impulszählers 4 veranlaßt den Impulszähler 4, den Zählerstand intern in ein Halteregister zu schreiben und sofort weiterzuzählen. Der Mikroprozessor µP kann den Zählstand aus dem Halteregister lesen.

Die steigende Flanke an Gate 1 des Impulszählers 4 darf aber frühestens 37 ns nach einer steigenden Flanke an Source 1 und spätestens 100 ns vor einer steigenden Flanke an Source 1 auftreten. Dies wird durch das Flipflop 18 sichergestellt. Die Flanke am Gate 1 erscheint um die Laufzeit des Flipflops 18 (50 ns) später als an Source 1.

Die steigende Flanke wird erzeugt durch den Quarzimpulsgeber 8, durchläuft den Frequenzteiler 25, gelangt zu dem Zeitimpulszähler 7 sowie zu dem Flipflop 27 und dem Monoflop 28, wenn das Zusatzsignal eine vorgegebene Zeit High-Pegel hatte.

Die im Quarzimpulsgeber 8 und im Frequenzteiler 25 erzeugte Frequenz wird auf Source 2 des Zeitimpulszählers 7 gelegt. Der Zeitimpulszähler 7 wird mit einer bestimmten Impulszahl durch den Mikroprozessor µP vorgeladen. Durch das an Gate 2 liegende Zusatzsignal (synchronisiert mit dem Source 2-Signal im Flipflop 27, vgl. Beschreibung des Flipflops 18) wird nur gezählt, wenn Gate 2 des Zeitimpulszählers 7 High-Pegel hat. Erreicht der Zeitimpulszähler 7 die vorgeladene Impulszahl, so wird

1. an OUT 2 ein Impuls ausgelöst,
2. der Zeitimpulszähler 7 im folgenden intern auf 0 gesetzt und
3. der nächste Count wieder gezählt.

Der an OUT 2 ausgelöste Impuls gelangt über das Monoflop 28 auf das Flipflop 18 und veranlaßt dort die Übernahme der Zählerstände (s.o.). Ebenso gelangt das Signal INT (Interrupt) zum Mikroprozessor µP und startet dort ein Programm, um den Zählerstand des Lesesignal-Impulszählers 4 auszulesen.

Bezugszeichenliste

1 = Leitung
2 = UND-Gatter
3 = Leitung
4 = Impulszähler
5 = Leitung
6 = Leitung
7 = Zeitimpulszähler
8 = Quarzimpulsgeber
9 = Leitung
10 = UND-Gatter
11 = Leitung
12 = Leitung
13 = Leitung
14 = Mikroprozessor
15 = Leitung
16 = Leitung
17 = Zähleinheit
18 = Flip-Flop
19 = UND-Gatter
20 = -
21 = Flip-Flop
22 = Flip-Flop
23 = Inverter
24 = -
25 = Frequenzteiler
26 = -
27 = Flip-Flop
28 = Mono-Flop
29 = -
30 = Zusatzsignal
31 = Zählerstand 1
32 = Auslesen
33 = Vorwahlwert
34 = Vorwahl erreicht
35 = Zählerstand 2
36 = $f = \dfrac{\text{Zählerstand 1}}{\text{Zählerstand 2}}$
37 = Größe des Mittelwert-Intervalls
38 = Source 1
39 = Gate 1
40 = Out 1
41 = Source 2
42 = Gate 2
43 = Out 2
44 = 5 MHz/F Out
45 = Zusatzsignal

**Patentansprüche**

1. Elektrische Schaltung zum Bestimmen der Frequenz von Laserdopplersignalen innerhalb eines Meßintervalls mit
   - einem Zähler (4) zum Zählen der Laserdoppler-Signalimpulse,
   - einem Zeitimpulsgeber, beispielsweise einem Quarzimpulsgeber (8), zum Erzeugen von Zeitimpulsen,
   - einem Zähler (7) zum Zählen der Zeitimpulse,
   - einem dem Signalimpulszähler (4) vorgeschalteten, von einem Zusatzsignal gesteuerten ersten Sperrelement, beispleisweise einem ersten UND-Gatter (2), zur Steuerung der Zählung der Signalimpulse, wobei das Zusatzsignal, beispielweise von einem automatischen Bandpaß, das Vorhandensein gültiger Signalimpulse anzeigt,
   - einem dem Zeitimpulszähler (7) vorgeschalteten, von dem Zusatzsignal gesteuerten zweiten Sperrelement, beispielsweise einem zweiten UND-Gatter (10), zur Steuerung der Zählung der Zeitimpulse,
   - einer zum Auslesen der Zählerstände nach Ablauf eines Meßintervalls mit dem Signalimpulszähler (4) und dem Zeitimpulszähler (7) verbundenen Steuereinrichtung, beispielsweise einem Mikroprozessor (14), dadurch **gekennzeichnet,** daß der Zeitimpulszähler (7) dazu ausgebildet ist, nach Erreichen einer vorgegebenen Anzahl von Zeitimpulsen, die das Meßintervall bestimmt, einen Auslesevorgang auszulösen, bei dem der Zählerstand des Signalimpulszählers (4) und der Zählerstand des Zeitimpulszählers (7) an den Mikroprozessor (14) übermittelt und zur Bestimmung der Frequenz der Laserdopplersignale genutzt wird.

2. Elektrische Schaltung nach Anspruch 1, dadurch **gekennzeichnet,** daß der Zusatzsignalgeber zum Synchronisieren der Impulszählungen mit dem Signalimpulszähler (4) und mit dem Zeitimpulszähler (7) gekoppelt ist.

3. Elektrische Schaltung nach Anspruch 1 oder 2, dadurch **gekennzeichnet**, daß der Signalimpulszähler (4) eine derartige Verbindung (16) mit dem Zeitimpulszähler (7) aufweist, daß bei kleinen Laserdopplersignal-Frequenzen und entsprechend wenig Laserdoppler-Signalimpulsen pro Meßintervall ein Übergang auf eine Periodendauermessung erfolgt.

4. Verfahren zum Bestimmen der Frequenz von Laserdopplersignalen innerhalb eines Meßintervalls, bei dem
   - ein Zusatzsignal erzeugt wird, das das Vorhandensein gültiger Laserdopplersignale anzeigt,
   - die Laserdoppler-Signalimpulse von einem Signalimpulszähler (4) gezählt werden, falls ein dem Signalimpulszähler (4) vorgeschaltetes erstes Sperrelement, beispielsweise ein erstes UND-Gatter (2), aufgrund des Zusatzsignals entsperrt ist,
   - von einem Zeitimpulsgeber, beispielsweise einem Quarzimpulsgeber (8), Zeitimpulse erzeugt werden,
   - die Zeitimpulse von einem Zeitimpulszähler (7) gezählt werden, falls ein den Zeitimpulszähler (7) vorgeschaltetes zweites Sperrelement, beispielsweise ein zweites UND-Gatter (10), aufgrund des Zusatzsignals entsperrt ist,
   - der Signalimpulszähler (4) seinen Zählerstand nach Beendigung des Meßintervalls an eine Steuereinrichtung, beispielsweise einen Mikroprozessor (14) überträgt; dadurch **gekennzeichnet**, daß der Zeitimpulszähler (7) nach Erreichen einer vorgegebenen Anzahl von Zeitimpulsen, die das Meßintervall bestimmt, einen Auslesevorgang auslöst, bei dem der Zählerstand des Signalimpulszählers (4) und der Zählerstand des Zeitimpulszählers (7) an den Mikroprozessor (14) übermittelt und zur Bestimmung der Frequenz der Laserdopplersignale genutzt wird.

5. Verfahren nach Anspruch 4, dadurch **gekennzeichnet,** daß das Zusatzsignal mit den Laserdoppler-Signalimpulsen und mit den Zeitimpulsen vor den Impulszählungen synchronisiert wird.

6. Verfahren nach Anspruch 4 oder 5, dadurch **gekennzeichnet,** daß bei kleinen Laserdopplersignal-Frequenzen und entsprechend wenig Laserdoppler-Signalimpulsen pro Meßintervall auf eine Periodendauermessung übergegangen wird.

**Claims**

1. Electrical circuit for determining the frequency of laser Doppler signals within a measuring interval having
   - a counter (4) for counting the laser Doppler signal pulses,
   - a time pulse transmitter, for example a quartz pulse transmitter (8), for producing time pulses,
   - a counter (7) for counting the time pulses,
   - a first blocking element, e.g. a first AND gate (2), controlled by an additional signal and connected upstream of the signal pulse counter (4) for controlling the count of the signal pulses, the additional signal, for example from an automatic band pass, indicating the presence of valid signal pulses,
   - a second blocking element, e.g. a second AND gate (10) controlled by the additional signal and connected upstream of the time pulse counter (7), for controlling the count of the time pulses,
   - a control device, e.g. a microprocessor (14), for reading out the counter readings at the end of a measuring interval and connected to the signal pulse counter (4) and the time pulse counter (7).

2. Electrical circuit according to claims 1, characterized in that the additional signal transmitter for synchronizing the pulse counts is linked with the signal pulse counter (4) and/or the time pulse counter (7).

3. Electrical circuit according to claim 1 or 2, characterized in that the signal pulse counter (4) has a connection (16) with the time pulse counter (7) such that in the case of small laser Doppler signal frequencies and correspondingly few laser Doppler signal pulses per measuring interval there is a transition to period length measurement.

4. Method for determining the frequency of laser Doppler signals within a measuring interval, in which
   - an additional signal is produced, which indicates the presence of valid laser Doppler signals,
   - the laser Doppler signal pulses from a signal pulse counter (4) are counted if a first blocking element, e.g. a first AND gate (2), connected upstream of the signal pulse counter (4) is unblocked as a result of the additional signal,
   - time pulses are produced by a time pulse transmitter, for example a quartz pulse transmitter (8),
   - the time pulses from a time pulse counter (7) are counted if a second blocking element, e.g. a second AND gate (10) connected upstream of the time pulse counter (7) is unblocked as a result of the additional signal,
   - the signal pulse counter (4) transfers its count at the end of the measuring interval to a control device, e.g. a microprocessor (14),
   characterized in that, after reaching a predetermined number of time pulses which determines the measuring interval, the time pulse counter (7) initiates a reading process, in which the count of the signal pulse counter (4) and the count of the time pulse counter (7) are passed to the microprocessor (14) and used for determining the frequency of the laser Doppler signals.

5. Method according to claim 4, characterized in that the additional signal is synchronized with the laser Doppler signal pulses and with the time pulses prior to the pulse counts.

6. Method according to 4 or 5, characterized in that with low laser Doppler signal frequencies and correspondingly few laser Doppler signal pulses per measuring interval there is a transition to a period length measurement.

**Revendications**

1. Circuit électrique pour déterminer la fréquence de signaux laser à effet Doppler à l'intérieur d'un intervalle de mesure avec
   - un compteur (4) pour compter des impulsions des signaux laser à effet Doppler,
   - un générateur d'impulsions horaires, par exemple un générateur d'impulsions à quartz (8), pour produire des impulsions horaires,
   - un compteur (7) pour compter les impulsions horaires,
   - un premier élément de blocage précédent le compteur d'impulsions de signaux (4), commandé par un signal auxiliaire, par exemple une première porte ET (2) pour la commande du comptage des impulsions des signaux, le signal auxiliaire, par exemple d'un passe-bande automatique, indiquant l'existence d'impulsions de signaux valables,
   - un second élément de blocage précédent le compteur d'impulsions horaires (7), commandé par le signal auxiliaire, par exemple une seconde porte ET (10), pour la commande du comptage des impulsions horaires,
   - un dispositif de commande, par exemple un microprocesseur (14), relié au compteur d'impulsions de signaux (7) et au compteur d'impulsions horaires (4), pour extraire les positions de compteur après écoulement d'un intervalle de mesure,
   **caractérisé en ce** que le compteur d'impulsions horaires (7) est conçu pour, après avoir atteint un nombre prédéterminé d'impulsions horaires que détermine l'intervalle de mesure, déclencher un processus d'extraction pour lequel la position du compteur d'impulsions de signaux (4) et la position du compteur d'impulsions horaires (7) sont transmises au microprocesseur (14) et utilisées pour déterminer la fréquence des signaux laser à effet Doppler.

2. Circuit électrique selon la revendication 1, **caractérisé en ce** que le générateur de signal auxiliaire est couplé au compteur d'impulsions de signaux (4) et au compteur d'impulsions horaires (7) pour synchroniser les comptages d'impulsions.

3. Circuit électrique selon la revendication 1 ou 2, **caractérisé en ce** que le compteur d'impulsions de signaux (4) présente une connexion (16) avec le compteur d'impulsions horaires (7) qui est telle que, pour des petites fréquences de signaux laser à effet Doppler et lorsque, de manière correspondante, il y a peu d'impulsions de signaux à effet Doppler par intervalle de mesure, un passage à une mesure de durée de période est effectué.

4. Procédé pour déterminer la fréquence de signaux laser à effet Doppler à l'intérieur d'un intervalle de mesure pour lequel
   - un signal auxiliaire est produit qui indique l'existence de signaux laser à effet Doppler valables,

- les impulsions de signaux laser à effet Doppler sont comptées par un compteur d'impulsions de signaux (4), au cas où un premier élément de blocage, par exemple une première porte ET (2), qui précède le compteur d'impulsions de signaux (4), est débloqué en raison du signal auxiliaire,
- des impulsions horaires sont produites par un générateur d'impulsions horaires, par exemple un générateur d'impulsions à quartz (8),
- les impulsions horaires sont comptées par un compteur d'impulsions horaires (7), au cas où un second élément de blocage, par exemple une seconde porte ET (10), qui précède le compteur d'impulsions horaires (7), est débloqué en raison du signal auxiliaire,
- le compteur d'impulsions de signaux (4) transmet sa position de compteur, après écoulement de l'intervalle de mesure, à un dispositif de commande, par exemple à un microprocesseur (14),

**caractérisé en ce** que le compteur d'impulsions horaires (7) déclenche, après avoir atteint un nombre prédéterminé d'impulsions horaires que détermine l'intervalle de mesure, un processus d'extraction pour lequel la position du compteur d'impulsions de signaux (4) et la position du compteur d'impulsions horaires (7) sont transmises au microprocesseur (14) et utilisées pour déterminer la fréquence des signaux laser à effet Doppler.

5. Procédé selon la revendication 4, **caractérisé en ce** que le signal auxiliaire est synchronisé avec les impulsions de signaux laser à effet Doppler et avec les impulsions horaires avant les comptages d'impulsions.

6. Procédé selon la revendication 4 ou 5, **caractérisé en ce** que, pour des petites fréquences de signaux laser à effet Doppler et lorsque, de manière correspondante, il y a peu d'impulsions de signaux à effet Doppler par intervalle de mesure, il y a passage à une mesure de durée de période.

Fig. 1

Fig. 2